# EUROPÄISCHE PATENTSCHRIFT

(11) **EP 2 501 042 B1**
(45) Veröffentlichungstag und Bekanntmachung des Hinweises auf die Patenterteilung: **18.12.2013**
(21) Anmeldenummer: 11002165.6
(22) Anmeldetag: 16.03.2011
(51) Int. Cl.: H03K 17/082

(54) **Ansteuerschaltung und Verfahren zur Ansteuerung eines Leistungshalbleiterschalters**
Control circuit and method for controlling a high-performance semiconductor switch
Circuit d'attaque et procédé destiné à la commande d'un circuit semi-conducteur de puissance

(43) Veröffentlichungstag der Anmeldung: 19.09.2012
(73) Patentinhaber: CT-Concept Holding GmbH, 2504 Biel (CH)
(72) Erfinder: Thalheim, Jan, 2504 Biel (CH); Garcia, Olivier, 2555 Brügg (CH)
(74) Vertreter: Coehn, Markus

(56) Entgegenhaltungen:
- EP-A2- 0 190 925
- DE-A1- 3 243 467
- DE-A1- 4 410 978

## Beschreibung

Die Erfindung betrifft eine Ansteuerschaltung und ein Verfahren zur Ansteuerung eines Leistungshalbleiterschalters gemäss Oberbegriff der unabhängigen Ansprüche.

Bei Leistungshalbleiterbauelementen, insbesondere bei Leistungshalbleiterbauelementen mit einem MOSFET-Steuerkopf, dauert es in der Regel eine gewisse Zeit, bis das Leistungshalbleiterbauelement (im Folgenden auch kurz: Bauelement oder Bauteil) vollständig eingeschaltet ist und die Spannung, die über den Last- bzw. Leistungsanschlüssen des Bauelements abfällt, welche bei IGBTs der üblicherweise mit VCE bezeichneten Kollektor-Emitter-Spannung entspricht, auf die gewünschten niedrigen Werte abgeklungen ist. Im Fehlerfall, beispielsweise wenn ein IGBT bei einem Kurzschluss eingeschaltet wird, kann der sich ergebende Ausgangsstrom durch die Lastanschlüsse des Bauelements derart hoch werden, dass er die Werte für den Ausgangsstrom, die der IGBT im linearen Betriebsbereich bereitstellt, überschreitet. In einem solchen Falle erreicht der Ausgangsstrom einen Sättigungswert, wobei die Kollektor-Emitter-Spannung des IGBTs auf einem hohen Niveau verbleibt. Dies hat eine sehr hohe Verlustleistung des IGBTs zur Folge.

Es stellt sich somit die Notwendigkeit, die Energie im Leistungshalbleiterbauelement zu begrenzen, um dessen Zerstörung zu vermeiden. Hierzu wird die Einschaltzeit des Bauelements im Kurzschlussfall typischerweise auf 10 µs begrenzt. Zur Überwachung des ordnungsgemässen Betriebs wird üblicherweise ein sogenanntes VCE-Monitoring (VCE-Überwachung) eingesetzt, mit welcher erkannt werden kann, ob der Ausgangsstrom des Leistungshalbleiterschalters einen für dessen ordnungsmässigen Betrieb zulässigen Strom überschreitet, d.h. das VCE-Monitoring dient einer Überstromerkennung am Ausgang des Halbleiterschalters. Beim VCE-Monitoring wie beispielsweise in Dokument EP 0 190 925 A2 beschrieben wird die Kollektor-Emitter-Spannung des IGBTs, d.h. der Spannungsabfall über dem IGBT, gemessen und mit einem Sollwert (einer Referenzspannung) verglichen, der im ordnungsgemässen Betrieb (auch Normalbetrieb genannt) innerhalb der zulässigen Kurzschlussdauer unterschritten werden soll. Im Normalbetrieb ist die Kollektor-Emitter-Spannung nach Ablauf der oben erwähnten, für den Kurzschlussbetrieb zulässigen Zeit von typischerweise 10 µs üblicherweise auf einen Wert von unter 10 V abgeklungen. Abhängig von der Spannungsklasse des Bauelements, dessen Betriebsbedingungen, der für das Bauelement eingesetzten Technologie und der Einstellung des Ladungsträger-Plasmas im Bauelement sind jedoch auch höhere Werte für die Kollektor-Emitter-Spannung möglich und zulässig wie beispielsweise Kollektor-Emitter-Spannungswerte im Bereich von bis zu 1000 V bei IGBTs der Spannungsklasse 6.5 kV. Hier sinkt die Kollektor-Emitter-Spannung typischerweise erst nach einer längeren Einschaltdauer, als sie für den Kurzschlussfall zulässig wäre, unter 10 V.

Aus dem Stand der Technik sind mehrere Verfahren für das VCE-Monitoring bekannt. So offenbart die amerikanische Patentschrift US-A 4 423 457 ein Verfahren, bei dem die am Kollektor eines Transistors auftretende hohe Spannung mittels einer Diode auf Werte begrenzt wird, die mit der auf das Bauelement folgenden Schaltung verarbeitet werden können. Die Kathode der Diode ist mit dem Kollektor des Transistors verbunden. Eine innerhalb einer Ansteuerschaltung für den Transistor implementierte Stromquelle ist an die Anode der Diode angeschlossen. Die Diode weist eine Sperrspannung auf, die höher ist als die durch die Spannungsklasse des anzusteuernden Transistors definierte Spannung. Für noch höhere Sperrspannungen werden mehrere Dioden in Reihe geschaltet. Das Potential an der Anode der Diode folgt dem Potential des Kollektors des Transistors zuzüglich der Flussspannung der Diode solange, bis die Ausgangsspannung der an die Anode angeschlossenen Stromquelle auf einen durch die Ansteuerschaltung zur Verfügung gestellten Spannungswert begrenzt wird. Die maximal messbare Kollektor-Emitter-Spannung ist somit auf dessen Versorgungsspannung abzüglich der Flussspannung der Diode begrenzt. Mit dem in der US-A-4 423 457 beschriebenen Verfahren sind nach Ablauf der erlaubten Zeit für den Kurzschlussbetrieb typischerweise Kollektor-Emitter-Spannungen von unter 10 V messbar. Dies ist für IGBT-Spannungsklassen von 600 V bis 1700 V grundsätzlich ausreichend.

Während des Einschaltvorgangs im Normalbetrieb wird das VCE-Monitoring üblicherweise während einer Ausblendzeit deaktiviert. Die Ausblendzeit wird auf einfache Weise durch eine Kapazität eingestellt, die an die Stromquelle angeschlossen ist. Diese Kapazität wird während des ausgeschalteten Zustands des Transistors mittels einer Signalverarbeitungseinheit über einen Schalter entladen und beim Einschaltvorgang des Transistors über die Stromquelle geladen.

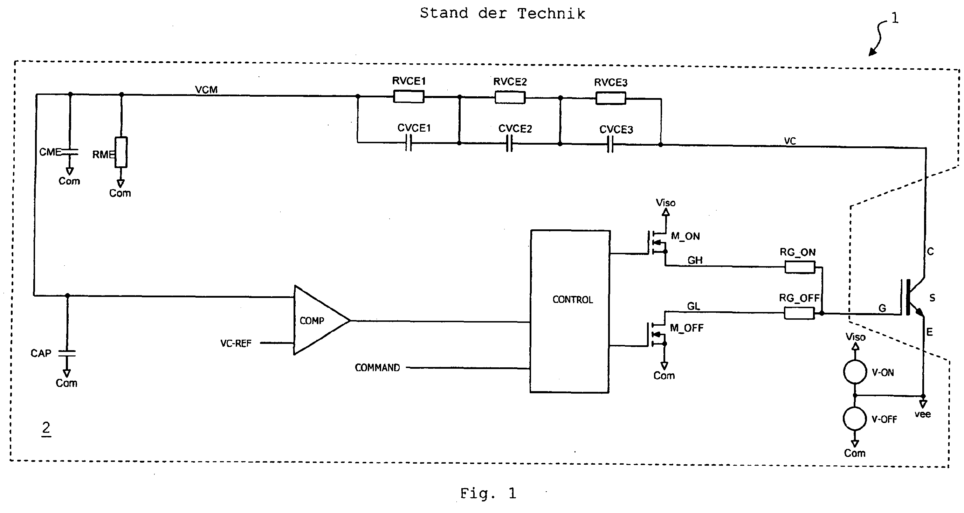

Aus "Universal Chipset for IGBT and Power-MOSFET Gate Drivers" von Jan Thalheim und Heinz Rüedi, PCIM Europe, Nürnberg, 2007, ist ebenfalls ein Verfahren zum VCE-Monitoring bekannt, welches im Folgenden anhand von Figur 1 erläutert wird. Figur 1 zeigt eine Schaltungsanordnung 1 mit einer Ansteuerschaltung 2 und einem Leistungshalbleiterschalter S mit angesteuertem Steueranschluss G (auch als Gate bezeichnet), welche VCE-Monitoring mittels eines kompensierten Spannungsteilers ermöglicht. Die Ansteuerschaltung 2 dient der Ansteuerung des Leistungshalbleiterschalters S. Ein Spannungsteiler, welcher durch die Widerstände RVCE1, RVCE2, RVCE3 und RME gebildet ist, wird eingesetzt, um die am Leistungsanschluss/Kollektor C des Leistungshalbleiterschalters S im Fehlerfall auftretende hohe Spannung auf Werte zu reduzieren, die innerhalb des zulässigen Eingangsspannungsbereichs des Komparators COMP der nachfolgenden/ nachgeschalteten Signalverarbeitungseinheit liegen. Bei dem Spannungsteiler sind die Widerstände RVCE1, RVCE2, RVCE3 in Reihe geschaltet. Die Werte der Widerstände RVCE1, RVCE2, RVCE3 müssen typischerweise sehr hoch gewählt werden, um die Verlustleistung innerhalb dieser Widerstände und somit die Kosten für die Bauteile und gegebenenfalls erforderliche Kühlmassnahmen möglichst gering zu halten. Wegen dieser hohen Werte für die Widerstände RVCE1, RVCE2, RVCE3 und der parasitären Eingangskapazität CAP der Signalverarbeitungseinheit bzw. des Komparators COMP (einschliesslich deren Verdrahtung) ergibt sich für die Schaltungsanordnung eine relativ hohe Zeitkonstante bzw. Ansprechzeit, die zu einer entsprechenden Signalverzögerung führt. Ferner kann die parasitäre Eingangskapazität CAP wertemässig prozessabhängig stark schwanken. Insbesondere bei einer komplexeren Verdrahtung mittels einer Leiterplatte (PCB - Printed Circuit Board) kann die parasitäre Eingangskapazität CAP stark vom Lagenaufbau, vom Hersteller und vom Produktionslos abhängen.

Zur Verminderung dieses Effekts, d.h. der gegebenenfalls durch die parasitäre Eingangskapazität CAP bedingten relativ hohen Zeitkonstanten, kann ein kompensierter Spannungsteiler eingesetzt werden, bei welchem den Widerständen RVCE1, RVCE2, RVCE3, RME dominante Kapazitäten CVCE1, CVCE2, CVCE3, CME zugeordnet sind (vgl. Figur 1). Nachteilig hierbei sind ein zusätzlich erforderlicher Platzbedarf, eine Verringerung der maximal zulässigen Betriebstemperatur, eine erhöhte Bauteilanzahl, erhöhte Kosten und in der Regel eine verringerte Zuverlässigkeit. Ein weiterer Nachteil des Einsatzes eines solchen kompensierten Spannungsteilers ist, dass bei einer monolithischen Integration des Komparators COMP und der Steuereinheit CONTROL der Signalverarbeitungseinheit eine Einstellung einer Ausblendzeit, in welcher das VCE-Monitoring deaktiviert ist, dem von dem Komparator COMP durchgeführten Vergleich der gemessenen Kollektor-Emitter-Spannung mit dem Sollwert nachgeschaltet werden muss, also innerhalb bzw. mittels der Steuereinheit CONTROL durchgeführt werden muss. Dies erfordert jedoch zusätzliche Massnahmen für die Einstellung der Ausblendzeit wie z.B. eine digitale Programmierung oder weitere Anschlusspins an der monolithisch integrierten Signalverarbeitungseinheit.

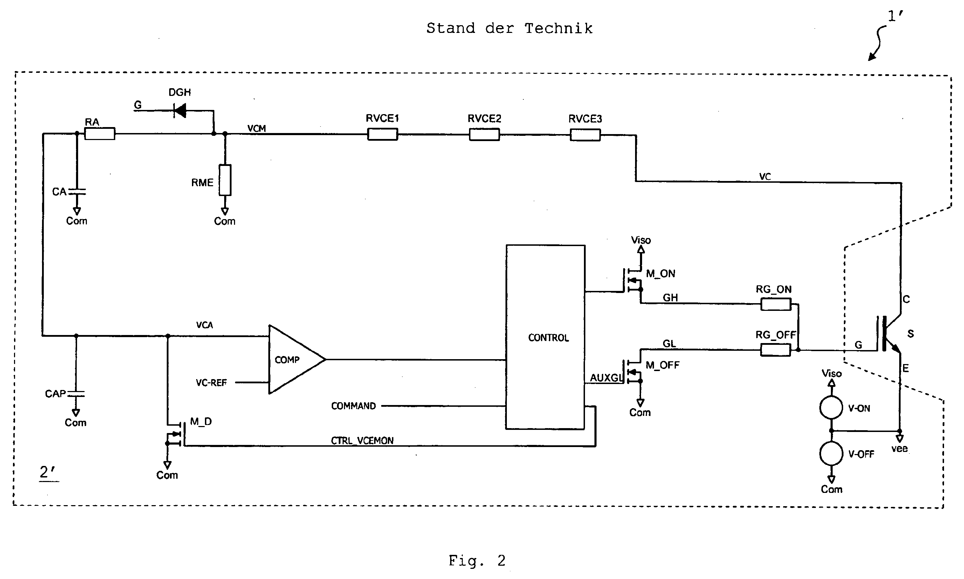

Die genannten Nachteile des kompensierten Spannungsteilers können vermieden werden, indem der oben genannte Spannungsteiler RVCE1, RVCE2, RVCE3, RME nicht durch dominante Kapazitäten kompensiert wird, sondern stattdessen die Eingangskapazität der dem Leistungshalbleiterschalter S folgenden Signalverarbeitungseinheit durch Parallelschaltung einer (dominanten) Ansprechzeit-Kapazität CA zu der parasitären Eingangskapazität CAP derart vergrössert wird, dass sich die für die Realisierung der Ausblendzeit des VCE-Monitorings notwendige Zeitkonstante der Ansteuerschaltung ergibt. Der Ansprechzeit-Kapazität CA ist typischerweise ein Ansprechzeit-Widerstand RA zugeordnet. Dies ist in Figur 2 dargestellt, welche eine Schaltungsanordnung 1' mit einer Ansteuerschaltung 2' und einem Leistungshalbleiterschalter S zeigt, mit welchen VCE-Monitoring ausgeführt werden kann. Während des ausgeschalteten Zustands des Leistungshalbleiterschalters S wird die Ansprechzeit-Kapazität CA mittels der Steuereinheit CONTROL über einen Schalter M_D auf ein niedrigeres Potential in Form eines vorgegebenen Bezugspotentials Com bzw. vee der Ansteuerschaltung 2' entladen. Beim Einschaltvorgang des Leistungshalbleiterschalters S wird die Ansprechzeit-Kapazität CA dann über das an den Kollektor C des Leistungshalbleiterschalters S angeschlossene Widerstandsnetzwerk RVCE1, RVCE2, RVCE3 geladen. Dabei führt allerdings eine Verringerung der Kollektor-Emitter-Spannung zu einer der Verringerung proportionalen Verlängerung der Ansprechzeit. Dies kann zu einer unbeabsichtigten Einschränkung hinsichtlich des optimalen Designs bzw. Betriebs des Leistungshalbleiterschalters S führen, obwohl bei der in Figur 2 dargestellten Schaltungsanordnung 1' die Kurzschlussenergie weitgehend konstant gehalten werden kann.

Um die Variation der Ansprechzeit in einem weiten Bereich der Kollektor-Emitter-Spannung zu minimieren, wird in "2SC0435T Description and Application Manual", CT-Concept Technolgie AG, Version 24. September 2010, (insbesondere S. 10), erhältlich über http://www.igbt-driver.com/fileadmin/Public/PDF/Products/ENG/SCALE-2/Cores/2SC0435T/2SC0435T_Manual.pdf), vorgeschlagen, das Potential VCM am Mittelpunkt des durch die Widerstände RVCE1, RVCE2, RVCE3, RME gebildeten Spannungsteilers mittels einer Diode DGH (vgl. Figur 2) auf einen maximalen Wert VCM_MAX, nämlich auf ein in der Ansteuerschaltung 2' für den Leistungshalbleiterschalter S verfügbares, zumindest teilweise konstantes Potential zuzüglich der Flussspannung der Diode DGH zu begrenzen. Für geringe Kollektor-Emitter-Spannungen wirkt der durch die Widerstände RVCE1, RVCE2, RVCE3, RME gebildete Spannungsteiler linear. Für grössere Kollektor-Emitter-Spannungen wird die Ausgangsspannung dieses Spannungsteilers mittels der Diode DGH auf den maximalen Wert VCM_MAX begrenzt. So sind gemäss Approximation für Kollektor-Emitter-Spannungen, die grösser sind als VCM*RVCE/(RME| |RA) der Wert für VCM und somit die Ansprechzeit konstant, wobei RVCE der Summe der Widerstandswerte der Widerstände RVCE1, RVCE2, RVCE3 entspricht und RME | | RA dem Widerstandswert der Parallelschaltung der Widerstände RME und RA entspricht. Der maximale Wert VCM_MAX kann beispielsweise aus der Betriebs-/Versorgungsspannung Viso oder aus einer in der Ansteuerschaltung 2' durch die Steuereinheit CONTROL geschalteten Spannung für den Steueranschluss G des Leistungshalbleiterschalters abgeleitet werden. Bei der geschalteten Spannung kann es sich um die Ausgangsspannung am Ausgang GH einer für den eingeschalteten Zustand des Leistungshalbleiterschalters S zuständigen Ausgangsstufe M_ON der Steuereinheit CONTROL handeln. Die Spannung VCM am Mittelpunkt des Spannungsteilers RVCE1, RVCE2, RVCE3, RME wird auf diesen maximalen Wert VCM_MAX begrenzt, solange die Kollektor-Emitter-Spannung grösser als ein vorgegebener Grenzwert VCE_MIN ist. Für Kollektor-Emitter-Spannungen, die unter dem Grenzwert VCE_MIN liegen, ist die Spannung am Mittelpunkt VCM des Spannungsteilers RVCE1, RVCE2, RVCE3, RME jedoch kleiner als der maximale Wert VCM_MAX, sodass sich auch hierbei die Ansprechzeit entsprechend verlängert. Die in "2SC0435T Description and Application Manual", CT-Concept Technolgie AG, Version 24. September 2010, beschriebene Ansteuerschaltung ist für IGBT-Spannungsklassen von 600 V bis 1700 V generell ausreichend.

Grundsätzlich sollte die durch die Ansprechzeit-Kapazität CA und den dieser zugeordneten Ansprechzeit-Widerstand RA (vgl. Figur 2) bestimmte Ansprechzeit der Schaltungsanordnung 1' bzw. Ansteuerschaltung 2' in einem weiten Bereich der Kollektor-Emitter-Spannung konstant gehalten werden. Dies wird durch Minimierung des Quotienten bzw. Faktors VCE_MIN/VCM_MAX aus dem oben definierten Wert VCM_MAX und der vorgegebenen minimalen Kollektor-Emitter-Spannung VCE_MIN erreicht.

Eine Minimierung des Faktors VCE_MIN/VCM_MAX kann beispielsweise dadurch erreicht werden, dass der zum Mittelpunkt VCM des durch die Widerstände RVCE1, RVCE2, RVCE3, RME gebildeten Widerstandsnetzwerks fliessende Strom vergrössert wird, zum Beispiel dadurch, dass die Widerstandwerte des an den Kollektor C des Leistungshalbleiterschalters S angeschlossenen Widerstandsnetzwerkes RVCE1, RVCE2, RVCE3 verringert werden. Diese Massnahme steht jedoch im Widerspruch dazu, dass wie eingangs erwähnt die Werte der mit dem Kollektor C in Serie geschalteten Widerstände RVCE1, RVCE2, RVCE3 des Widerstandsnetzwerkes sehr hoch gewählt werden sollten, um die durch eine hohe Kollektor-Emitter-Spannung verursachte Verlustleistung innerhalb der Widerstände RVCE1, RVCE2, RVCE3 und somit die Kosten für die Bauteile und gegebenenfalls erforderliche Kühlmassnahmen möglichst gering zu halten.

Alternativ kann der Faktor VCE_MIN/VCM_MAX dadurch minimiert werden, dass der vom Mittelpunkt VCM des durch die Widerstände RVCE1, RVCE2, RVCE3, RME gebildeten Widerstandsnetzwerks abfliessende Strom verringert wird, zum Beispiel indem der Wert des Ansprechzeit-Widerstands RA vergrössert bzw. maximiert wird. Ausserdem könnte auch der Wert des Widerstands RME des Spannungsteilers vergrössert werden. Bei der in Figur 2 dargestellten Schaltungsanordnung 1' kann der Widerstand RME entfallen, da die Eingangsspannung für den Komparator COMP bereits durch die Diode DGH begrenzt wird. Diese Massnahmen hätten jedoch zur Folge, dass bei vorgegebener Ansprechzeit der Wert für die Ansprechzeit-Kapazität CA entsprechend verringert werden müsste, was dazu führen würde, dass die Ansprechzeit stärker von der parasitären und prozessabhängigen Kapazität CAP beeinflusst werden würde. Insbesondere bei einer kostengünstigen, kompakten Bauweise der Schaltungsanordnung mit einer komplexeren Ansteuerschaltung (auch Treiberschaltung genannt) sind die parasitären Effekte typischerweise derart dominierend, dass sich eine serientaugliche Abstimmung der Ansprechzeit der Schaltungsanordnung vor allem bezüglich Prozess-Kontrolle und thermischer Belastung der Bauteile nur schwer realisieren lässt, insbesondere bei IGBT-Spannungsklassen von 3300 V bis 6500 V.

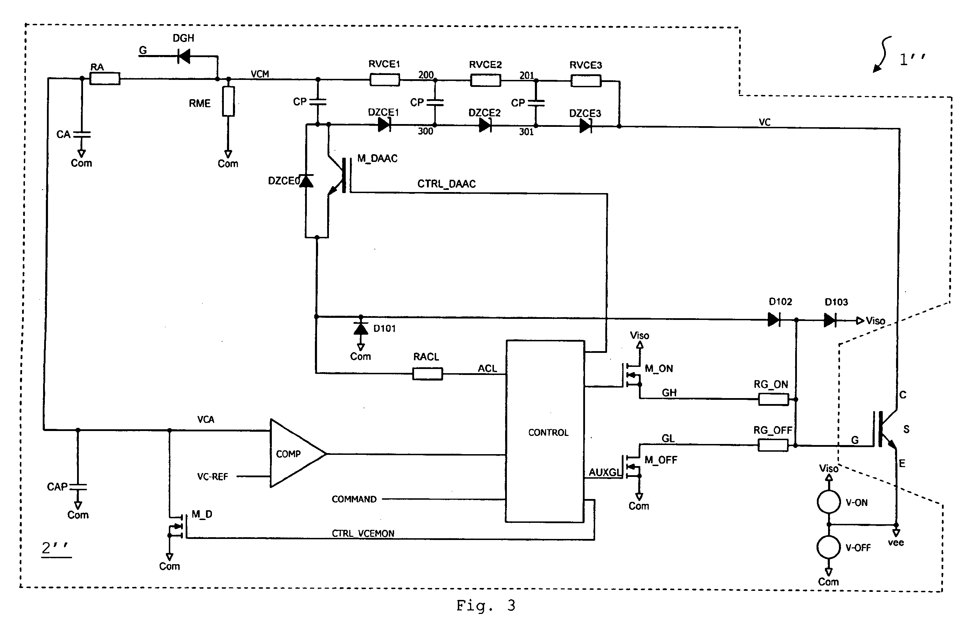

Die Auswirkung parasitärer Effekte wird noch relevanter und somit die serientaugliche Abstimmung noch erschwert, wenn durch die Ansteuerschaltung sowohl das eingangs beschriebene VCE-Monitoring, d.h. die Überwachung der Kollektor-Emitter-Spannung des Leistungshalbleiterschalters S als auch eine dynamische, sogenannte Active-Clamping-Funktion (aktive Klemm-Funktion bzw. Abschaltüberspannungbegrenzungsfunktion) realisiert werden sollen. Die Active-Clamping-Funktion dient dazu, eine beim Abschalten des Leistungshalbleiters S gegebenenfalls auftretende Überspannung zu begrenzen. Eine Schaltungsanordnung 1" mit einer derartigen Ansteuerschaltung 2" ist in Figur 3 dargestellt (zum Anmeldedatum internes Wissen der Anmelderin).

Mittels der Active-Clamping-Funktion wird eine beim Abschalten des Leistungshalbleiterschalters S gegebenenfalls auftretende Überspannung mit Hilfe von reihengeschalteten Halbleiterbauelementen DZCE0, DZCE1, DZCE2, DZCE3 (beispielsweise Zener-Dioden, Avalanche-Dioden (vgl. http://de.wikipedia.org/wiki/Avalanchediode) und/oder Transient-Voltage-Suppressor-Dioden (vgl. http://de.wikipedia.org/wiki/Suppressordiode)), die beim Überschreiben einer bestimmten Kollektor-Emitter-Spannung im Durchbruch betrieben werden, dadurch begrenzt, dass der Leistungshalbleiterschalter S wieder eingeschaltet wird, wobei das Potential am Steueranschluss G des Leistungshalbleiterschalters S zeitweise etwa auf das Niveau der Speisungs-/Versorgungsspannung Viso gehoben wird.

Die Wirksamkeit der Active-Clamping-Funktion kann noch dadurch verbessert werden, dass der an der Steueranschluss-Leitung (auch Gate-Leitung genannt), welche von der Steuereinheit CONTROL (auch Gate-Treiber genannt) zum Steueranschluss G des Leistungshalbleiterschalters S führt, verfügbare Ausgangsstrom der Steuereinheit CONTROL reduziert wird. Dies wird dadurch erreicht, dass ein Teil des Stroms der im Durchbruch betriebenen Halbleiterbauelemente DZCE0, DZCE1, DZCE2, DZCE3 über einen Widerstand RACL auf einen Steuereingang ACL der Steuereinheit CONTROL zurückgeführt wird. Der Steuereingang ACL ist vorzugsweise ein nieder-impedanter Eingang einer Stromspiegelschaltung, wobei in Abhängigkeit des in den Steuereingang ACL fliessenden Stroms der am Ausgang GL einer für den ausgeschalteten Zustand bzw. Ausschaltvorgang des Leistungshalbleiterschalters S zuständigen Ausgangsstufe M_OFF der Steuereinheit CONTROL verfügbare Ausgangsstrom reduziert wird.

Gemäss Stand der Technik ist bei einer dynamischen Active-Clamping-Funktion ein Halbleiterbauelement DZCE0 der in Reihe geschalteten, im Durchbruch betriebenen Halbleiterbauelemente DZCE0, DZCE1, DZCE2, DZCE3 für eine gewisse Zeit während des Abschaltvorgangs des Leistungshalbleiterschalters S überbrückt. Ziel der dynamischen Active-Clamping-Funktion ist es, einerseits die Summe der Durchbruchspannungen im abgeschalteten Zustand des Leistungshalbleiterschalters S zu erhöhen und andererseits die Summe der Durchbruchspannungen während des eigentlichen Abschaltvorgangs zu verringern, sodass die Leistungsfähigkeit des Leistungshalbleiterschalters S besser ausgenutzt werden kann, ohne dessen sicheren Arbeitsbereich zu verlassen.

Bei der Realisierung des VCE-Monitorings und der dynamischen Active-Clamping-Funktion in einer Schaltungsanordnung 1" bzw. Ansteuerschaltung 2", wie in Figur 3 dargestellt, ergeben sich jedoch die folgenden Schwierigkeiten. Wie oben erwähnt wird ein Halbleiterbauelement DZCE0 bzw. ein Teil der reihengeschalteten, bei Überschreitung einer bestimmten Kollektor-Emitter-Spannung im Durchbruch betriebenen Halbleiterbauelemente DZCE0, DZCE1, DZCE2, DZCE3 während des Abschaltvorgangs des Leistungshalbleiterschalters S für eine gewisse Zeit überbrückt. Die Überbrückung erfolgt mittels eines Schalters M_DAAC, der über einen Steueranschluss CTRL_DAAC von der Steuereinheit CONTROL angesteuert wird.

Wird der Schalter M_DAAC allerdings während eines Einschaltvorgangs des Leistungshalbleiterschalters S eingeschaltet, dann ergibt sich aufgrund der Änderung des Spannungsabfalls über M_DAAC ein ungewollter Ladungstransfer zwischen den parasitären Kapazitäten CP und der Ansprechzeit-Kapazität CA. Hierdurch wird die Abstimmung der Ansprechzeit bzw. Ansprechzeitkonstanten, insbesondere die Einhaltung von geringen Toleranzen der Ansprechzeit bei Prozessschwankungen weiter erschwert. Die Minimierung des Einflusses der parasitären Kapazitäten CP, die sich zwischen den Widerständen RVCE1, RVCE2, RVCE3 der Widerstands-Reihenschaltung und den Anoden der Halbleiterbauelementen DZCE1, DZCE2, DZCE3 ergeben, würde in der in Figur 3 dargestellten Schaltungstopologie eine relativ komplexe Steuerung des optimalen Zeitpunkts für den Wechsel des Schaltzustandes des Schalters M_DAAC und somit eine komplexe Steuereinheit CONTROL erfordern. Eine komplexe Steuereinheit CONTROL erfordert jedoch auch eine aufwändige Speisung der Steuereinheit CONTROL. Insbesondere ist es erforderlich, dass die Steuereinheit CONTROL derart ausgestaltet ist, dass sie bei Überschreiten der Durchbruchspannungen der Halbleiterbauelemente DZCE1, DZCE2, DZCE3 während des Abschaltvorgangs des Leistungshalbleiterschalters S wegen einer am Leistungshalbleiterschalter S auftretenden Überspannung den Leistungshalbleiterschalter S zeitweise wieder einschaltet, indem das Potential am Steueranschluss G des Leistungshalbleiterschalters S zeitweise etwa auf das Niveau der Versorgungsspannung Viso angehoben wird. Die Steuereinheit CONTROL muss also zur Durchführung der Active-Clamping-Funktion ausgestaltet sein. Zusätzlich muss die Steuereinheit CONTROL zur gleichen Zeit dafür sorgen, dass der Schalter M_DAAC sicher eingeschaltet bleibt, um den Nennwert für die zulässige Überspannung während des Abschaltvorgangs des Leistungshalbleiterschalters nicht ungewollt zu erhöhen. Hierfür ist es erforderlich, dass das Potential am Steueranschluss CTRL_DAAC des Schalters M_DAAC höher ist als das Potential am Steueranschluss G des Leistungshalbleiterschalters S und ferner höher ist als das Niveau der Versorgungsspannung Viso. Dies erfordert üblicherweise den Einsatz relativ komplexer sogenannter Chargepump- (Ladungspumpe-) oder Bootstrap-Speisungen. Wegen der hohen Ladung am Steueranschluss des Schalters M_DAAC ergibt sich jedoch eine relativ hohe Belastung der Speisung, insbesondere wenn der Leistungshalbleiterschalter S bei höheren Schaltfrequenzen betrieben wird.

Es ist Aufgabe der Erfindung, eine gegenüber den eingangs beschriebenen Ansteuerschaltungen verbesserte Ansteuerschaltung und ein gegenüber den eingangs beschriebenen Verfahren verbessertes Verfahren zur Ansteuerung eines Leistungshalbleiterschalters bereitzustellen, mit denen der Einfluss parasitärer Kapazitäten verringert, insbesondere minimiert werden kann. Es ist ferner Aufgabe der Erfindung, eine Ansteuerschaltung und ein Verfahren zur Ansteuerung eines Leistungshalbleiterschalters von geringer Komplexität, insbesondere von gegenüber der im Zusammenhang mit Figur 3 beschriebenen Ansteuerschaltung bzw. dem entsprechenden Verfahren verringerter Komplexität, bereitzustellen. Es ist weiter Aufgabe der Erfindung, eine Ansteuerschaltung und ein Verfahren zur Ansteuerung eines Leistungshalbleiterschalters bereitzustellen, bei dem die thermische Belastung der Bauteile gering ist, insbesondere gegenüber den eingangs beschriebenen Ansteuerschaltungen bzw. Verfahren verringert bzw. minimiert ist. Es ist weiterhin Aufgabe der Erfindung, eine Ansteuerschaltung und ein Verfahren zur Ansteuerung eines Leistungshalbleiterschalters bereitzustellen, welche eine einfache Abstimmung der Ansteuerschaltung und dessen Ansprechzeit ermöglichen, insbesondere im Vergleich mit den eingangs beschriebenen Ansteuerschaltungen bzw. Verfahren. Es ist ferner Aufgabe der Erfindung, eine Ansteuerschaltung und ein Verfahren mit gegenüber (Herstellungs-)Prozessschwankungen verbesserter Stabilität bzw. Robustheit bereitzustellen. Es ist ausserdem Aufgabe der Erfindung, eine Ansteuerschaltung und ein Verfahren zur Ansteuerung eines Leistungshalbleiterschalters bereitzustellen, mit welchen neben VCE-Monitoring eine dynamische Active-Clamping-Funktion realisiert werden kann, wobei insbesondere der Aufwand für die erforderliche Steuerung und Speisung gegenüber der in Zusammenhang mit Figur 3 beschriebenen Ausgestaltung verringert ist.

Diese Aufgabe wird durch eine Ansteuerschaltung und ein Verfahren mit den Merkmalen der unabhängigen Ansprüche gelöst.

Die erfindungsgemässe Ansteuerschaltung zur Ansteuerung eines Leistungshalbleiterschalters weist eine Signalverarbeitungseinheit zur Erzeugung eines Steueranschluss-Signals für einen Steueranschluss (auch Gate genannt) eines Leistungshalbleiterschalters auf. Die Ansteuerschaltung umfasst eine Widerstands-Reihenschaltung, welche an einen der Stromzuführung dienenden Leistungsanschluss, der im Folgenden auch als Kollektor bezeichnet wird, des Leistungshalbleiterschalters anschliessbar ist und dessen Ausgang - zumindest mittelbar - mit einem ersten Eingang der Signalverarbeitungseinheit verbunden ist. Die Signalverarbeitungseinheit weist einen zweiten Eingang für eine Referenzspannung für die Kollektor-Emitter-Spannung des Leistungshalbleiterschalters auf. Ferner umfasst die Ansteuerschaltung wenigstens ein Halbleiterbauelement, das derart ausgestaltet ist, dass es bei Überschreiten einer bestimmten, vorgegebenen Kollektor-Emitter-Spannung des Leistungshalbleiterschalters im Durchbruch betrieben wird. Ein Ausgang des wenigstens einen Halbleiterbauelements ist über eine leitfähige Verbindung mit einem zwischen den Widerständen der Widerstands-Reihenschaltung oder mit dem Ausgang der Widerstands-Reihenschaltung, der mit der Signalverarbeitungseinheit verbunden ist, verbunden. Die leitfähige Verbindung weist vorzugsweise keine elektronischen Bauelemente auf. Die Durchbruchspannung des wenigstens einen Halbleiterbauelements ist derart gewählt, dass das Potential an dem Ausgang des wenigstens einen Halbleiterbauelements, welcher an die leitfähige Verbindung angeschlossen ist, grösser als das Potential am Steueranschluss des Leistungshalbleiterschalters im eingeschalteten Zustand des Leistungshalbleiterschalters, insbesondere grösser als 100 V, ist. Das Potential an diesem Ausgang des wenigstens einen Halbleiterbauelements entspricht vorzugsweise dessen Durchbruchspannung, die bevorzugt grösser als 100 V ist.

Gemäss bevorzugter Ausgestaltung ist ein Ansprechzeit-Netzwerk vorgesehen, welches zumindest einen Ansprechzeit-Widerstand umfasst, über welches der kollektorferne Ausgang der Widerstands-Reihenschaltung mit dem ersten Eingang der Signalverarbeitungseinheit verbunden ist, wobei die Ansprechzeit der Ansteuerschaltung von der Zeitkonstanten des Ansprechzeit-Netzwerks abhängt.

Bei dem erfindungsgemässen Verfahren zur Ansteuerung eines Leistungshalbleiterschalters mittels der erfindungsgemässen Ansteuerschaltung ermittelt die Signalverarbeitungseinheit aus dem an seinem ersten Eingang anliegenden Signal und aus der Referenzspannung für die Kollektor-Emitter-Spannung des Leistungshalbleiterschalters ein Steueranschluss-Signal für den Steueranschluss des Leistungshalbleiterschalters. Beim Überschreiten der bestimmten, vorgegebenen Kollektor-Emitter-Spannung wird das wenigstens eine Halbleiterbauelement dann im Durchbruch betrieben und das Potential an dem mit der leitfähigen Verbindung verbundenen Ausgang der Widerstands-Reihenschaltung bzw. an dem mit der leitfähigen Verbindung verbundenen, zwischen den Widerständen der Widerstands-Reihenschaltung liegenden Anschluss wird auf einen Wert begrenzt, der grösser ist als das Potential am Steueranschluss des Leistungshalbleiterschalters im eingeschalteten Zustand des Leistungshalbleiterschalters und der vorzugsweise grösser als 100 V ist. Das Potential an dem mit der leitfähigen Verbindung verbundenen Ausgang der Widerstands-Reihenschaltung bzw. an dem mit der leitfähigen Verbindung verbundenen, zwischen den Widerständen der Widerstands-Reihenschaltung liegenden Anschluss entspricht vorzugsweise im Durchbruch des wenigstens einen Halbleiterbauelements dessen Durchbruchspannung. Das an dem ersten Eingang der Signalverarbeitungseinheit anliegende Signal ist aus dem Potential am Kollektor des Leistungshalbleiterleiters abgeleitet und wird zur Erzeugung des Steueranschluss-Signals für dessen Steueranschluss von der Signalverarbeitungseinheit mit der Referenzspannung verglichen.

Mittels der erfindungsgemässen Ansteuerschaltung und dem erfindungsgemässen Verfahren wird vorteilhafterweise das Konstanthalten der Ansprechzeit in einem weiten Bereich der für die Kollektor-Emitter-Spannung möglichen Werte wesentlich vereinfacht. Der Einfluss und die Problematik parasitärer Kapazitäten können vermindert werden. Die erfindungsgemässe Ansteuerschaltung und das erfindungsgemässe Verfahren sind sowohl für das Einschalten eines Leistungshalbleiterschalters in den Kurzschluss (sogenannter Kurzschluss vom Typ 1) als auch für den Fall eines Kurzschlusses im eingeschalteten Zustand des Halbleiterschalters (sogenannter Kurzschluss vom Typ 2) geeignet.

Des weiteren weist die erfindungsgemässe Ansteuerschaltung mehrere in Reihe geschaltete Halbleiterbauelemente auf, die bei Überschreiten der bestimmten, vorgegebenen Kollektor-Emitter-Spannung für den Leistungshalbleiterschalter im Durchbruch betrieben werden und von denen das oben genannte, wenigstens eine Halbleiterbauelement eines ist. Bei Überschreiten der Durchbruchspannung der in Reihe geschalteten Halbleiterbauelemente hebt die Signalverarbeitungseinheit vorzugsweise den momentanen Wert des Steueranschluss-Signals für den Steueranschluss des Leistungshalbleiterschalters an. Durch diese Massnahmen kann neben einem VCE-Monitoring (d.h. einer Überstromerkennung) eine dynamische Active-Clamping-Funktion (Abschaltüberspannungbegrenzungsfunktion) für einen Leistungshalbleiterschalter realisiert werden.

Der Leistungshalbleiterschalter, der durch die erfindungsgemässe Ansteuerschaltung und das erfindungsgemässe Verfahren angesteuert bzw. betrieben werden kann, kann beispielsweise Bestandteil eines Schaltermoduls, insbesondere eines Halbbrückenzweigs eines Umrichters, für Traktion/Zugbetrieb, für industrielle elektrische Antriebe, für Solarenergie, für Windenergie, für Hochspannungsgleichstromübertragung und/oder für ein flexibles Drehstromübertragungssystem (FACTS) bilden. Insbesondere kann der Leistungshalbleiterschalter ein Bipolartransistor (BJT), ein Bipolartransistor mit integrierter Gate-Elektrode (IGBT), ein Metall-Oxid-Halbleiter-Feldeffekttransistor (MOSFET) oder eine Kombination aus diesen Bauelementen sein.

Weitere vorteilhafte Ausgestaltungen der Erfindung ergeben sich aus den abhängigen Ansprüchen und den anhand der Zeichnungen nachfolgend dargestellten Ausführungsbeispielen. Es zeigen:
Fig. 1 ein schematisches Schaltbild einer bekannten Schaltungsanordnung mit einer Ansteuerschaltung mit VCE-Monitoring und einem Leistungshalbleiterschalter,
Fig. 2 ein schematisches Schaltbild einer weiteren bekannten Schaltungsanordnung mit einer Ansteuerschaltung mit VCE-Monitoring und einem Leistungshalbleiterschalter,
Fig. 3 ein schematisches Schaltbild einer Schaltungsanordnung mit einer Ansteuerschaltung mit VCE-Monitoring und Realisierung einer Active-Clamping-Funktion und einem Leistungshalbleiterschalter, die zum Anmeldedatum internes Wissen der Anmelderin bildet,
Fig. 4 ein schematisches Schaltbild einer Schaltungsanordnung mit einer Ansteuerschaltung und einem Leistungshalbleiterschalter,
Fig. 5 ein schematisches Schaltbild einer Schaltungsanordnung mit einem ersten Ausführungsbeispiel einer erfindungsgemässen Ansteuerschaltung und einem Leistungshalbleiterschalter,
Fig. 6 ein schematisches Schaltbild einer Schaltungsanordnung einer Ansteuerschaltung und einem Leistungshalbleiterschalter und
Fig. 7 ein schematisches Schaltbild einer Schaltungsanordnung mit einem zweiten Ausführungsbeispiel einer erfindungsgemässen Ansteuerschaltung und einem Leistungshalbleiterschalter.

Gleiche Bezugszeichen in den Figuren bezeichnen gleiche bzw. gleich wirkende Komponenten bzw. Elemente. Die Figuren 1 bis 3 sind bereits in der Beschreibungseinleitung beschrieben und es wird auf diese verwiesen.

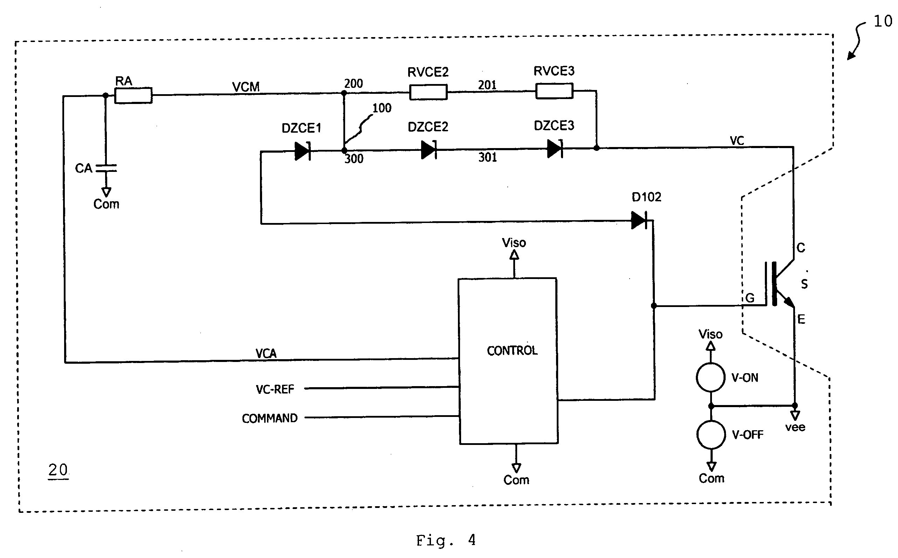

Figur 4 zeigt eine Schaltungsanordnung 10 mit einer beispielhaften Ansteuerschaltung 20 und einem Leistungshalbleiterschalter S. Die Ansteuerschaltung 20 weist eine Signalverarbeitungseinheit CONTROL auf, die einen ersten Eingang für eine aus einer Kollektor-Emitter-Spannung des Leistungshalbleiterschalters S abgeleitete Spannung VCA und einen zweiten Eingang für eine Referenzspannung VC-REF aufweist. Die Signalverarbeitungseinheit CONTROL umfasst einen Komparator, der die Spannung VCA unter Bildung eines Vergleichswerts mit der Referenzspannung VC-REF vergleicht. Die Signalverarbeitungseinheit CONTROL umfasst ferner eine Steuereinheit, die abhängig von dem Vergleichswert ein Steueranschluss-Signal über einen Steuerausgang an den Steueranschluss G des Leistungshalbleiterschalters S ausgibt. Der Komparator und die Steuereinheit sind in dem in Figur 4 dargestellten Ausführungsbeispiel integriert als Signalverarbeitungseinheit CONTROL dargestellt.

Die Ansteuerschaltung 20 umfasst ferner eine Widerstands-Reihenschaltung aus den Widerständen RVCE2 und RVCE3, die an den Kollektor C des Leistungshalbleiterschalters S angeschlossen ist und deren kollektorferner Ausgang mit dem Potential VCM vorzugsweise über ein aus einem Ansprechzeit-Widerstand RA und aus einer diesem zugeordneten, mit einem Bezugspotential Com verbundenen Ansprechzeit-Kapazität CA gebildeten Ansprechzeit-Netzwerk mit dem ersten Eingang der Signalverarbeitungseinheit CONTROL verbunden ist, an welchem die Spannung bzw. das Potential VCA anliegt. Die Widerstands-Reihenschaltung dient dem VCE-Monitoring.

Weiter umfasst die Ansteuerschaltung 20 eine Reihenschaltung aus Halbleiterbauelementen DZCE1, DZCE2, DZCE3, die derart ausgelegt sind, dass sie bei einer bestimmten, vorgegebenen Kollektor-Emitter-Spannung des Leistungshalbleiterschalters S in den Durchbruch schalten. Bei den Halbleiterbauelementen DZCE1, DZCE2, DZCE3 handelt es sich insbesondere um Zener-Dioden, Avalanche-Dioden und/oder Transient-Voltage-Suppressor-Dioden. Die Halbleiterbauelemente-Reihenschaltung ist kathodenseitig mit dem Kollektor C des Leistungshalbleiterschalters S verbunden. Anodenseitig ist die Halbleiterbauelemente-Reihenschaltung, beispielsweise über eine in Gegenrichtung angeordnete Diode D102, mit dem Steuerausgang der Signalverarbeitungseinheit CONTROL verbunden. Durch die Halbleiterbauelemente-Reihenschaltung wird eine dynamische Active-Clamping-Funktion realisiert, wobei bei Überschreiten der Durchbruchspannungen der Halbleiterbauelemente DZCE1, DZCE2, DZCE3 die Signalverarbeitungseinheit CONTROL vorzugsweise das Steueranschluss-Signal für den Steueranschluss G des Leistungshalbleiterschalters S bzw. dessen (momentanen) Wert anhebt.

Ein Anschluss 300 zwischen zwei Halbleiterbauelementen DZCE1, DZCE2 ist über eine leitende Verbindung 100 mit dem kollektorfernen Ausgang 200 der Widerstands-Reihenschaltung verbunden. Dies führt dazu, dass abweichend zu der in Figur 3 dargestellten Ansteuerschaltung 2" das Potential am Ausgang 200 der Widerstands-Reihenschaltung mittels der leitfähigen Verbindung 100 zumindest zeitweise, nämlich für die Zeit des Durchbruchs des Halbleiterbauelements DZCE1, konstant gehalten und somit stabilisiert wird, da es auf einen Wert begrenzt wird, der durch das im Durchbruch betriebene Halbleiterbauelement DZCE1, insbesondere durch dessen Durchbruchspannung, bestimmt wird. Dabei ist die Durchbruchspannung des Halbleiterbauelements DZCE1 vorzugsweise grösser als 100 V.

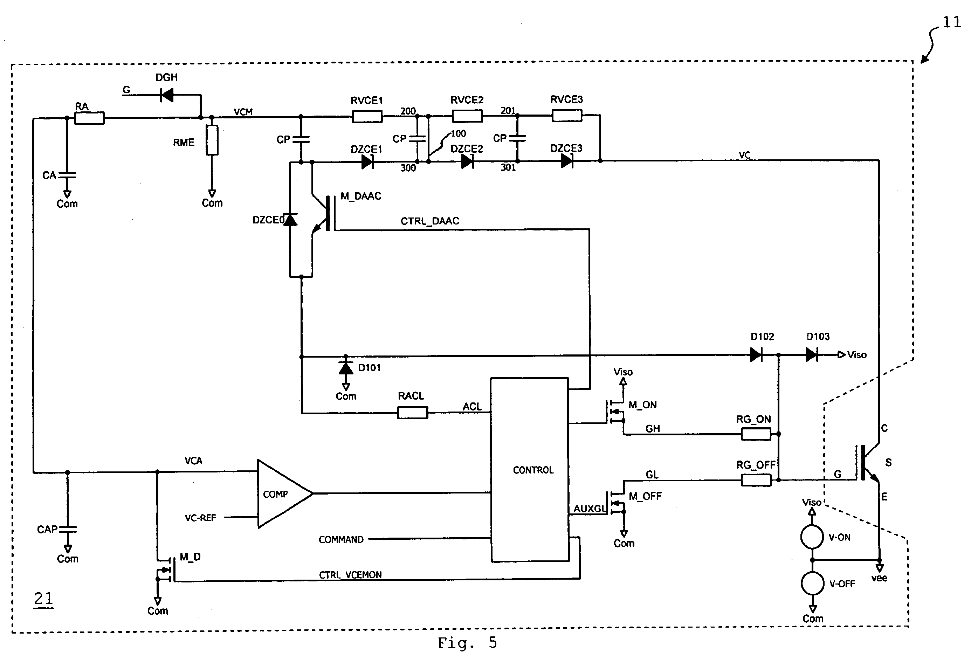

Figur 5 zeigt eine Schaltungsanordnung 11 mit einem ersten Ausführungsbeispiel einer Ansteuerschaltung 21 und einem Leistungshalbleiterschalter S, wobei der Komparator COMP und die Steuereinheit CONTROL der Signalverarbeitungseinheit separat ausgeführt sind und der Steuereinheit CONTROL zwei Ausgangsstufen M_ON und M_OFF zugeordnet sind, die jeweils mit dem Steueranschluss G des Leistungshalbleiterschalters S verbindbar bzw. verbunden sind. Über die Ausgangsstufe M_ON wird der Leistungshalbleiterschalter S von der Steuereinheit CONTROL eingeschaltet und im eingeschalteten Zustand betrieben. Über die Ausgangsstufe M_OFF wird der Leistungshalbleiterschalter S von der Steuereinheit CONTROL ausgeschaltet bzw. im ausgeschalteten Zustand betrieben.

Im Unterschied zu dem in Figur 4 dargestellten Beispiel weist die Widerstands-Reihenschaltung drei Widerstände RVCE1, RVCE2, RVCE3 auf. Ausserdem weist die Reihenschaltung aus Halbleiterbauelementen, die bei Überschreiten einer bestimmten, vorgegebenen Kollektor-Emitter-Spannung im Durchbruch betrieben werden, vier Halbleiterbauelemente DZCE0, DZCE1, DZCE2, DZCE3 auf. Das Halbleiterbaueelement DZCE0 weist vorzugsweise ebenfalls eine Durchbruchspannung von mehr als 100 V aus und kann ebenfalls als Zener-Diode, als Avalanche-Diode oder als Transient-Voltage-Suppressor-Diode ausgeführt sein. Der Anschluss 300 zwischen den zwei Halbleiterbauelementen DZCE1 und DZCE2 ist über die leitfähige Verbindung 100 mit einem Anschluss 200 zwischen den Widerständen RVCE1 und RVCE2 verbunden, d.h. mit dem von dem Ansprechzeit-Netzwerk aus gesehen ersten Zwischenanschluss 200 der Widerstands-Reihenschaltung, welches auf einem ersten Zwischenpotential liegt. Dieses Zwischenpotential wird mittels der leitfähigen Verbindung 100 zumindest zeitweise, nämlich für die Zeit des Durchbruchs des Halbleiterbauelements DZCE1, konstant gehalten und somit stabilisiert, indem es auf einen Wert begrenzt wird, der durch das im Durchbruch betriebene Halbleiterbauelement DZCE1, insbesondere durch dessen Durchbruchspannung, bestimmt wird, die vorzugsweise grösser als 100 V ist. Wie bei dem in Figur 4 gezeigten Beispiel hebt bei Überschreiten der Durchbruchspannungen der Halbleiterbauelemente DZCE0, DZCE1, DZCE2, DZCE3 die Steuereinheit CONTROL vorzugsweise das Steueranschluss-Signal für den Steueranschluss G des Leistungshalbleiterschalters S bzw. dessen (momentanen) Wert an.

Vorteil der Stabilisierung des Potentials am Zwischenanschluss bzw. Ausgang 200 der Widerstands-Reihenschaltung ist es, dass der unerwünschte Einfluss parasitärer Kapazitäten CP, die den Widerständen RVCE1, RVCE2, RVCE3 der Widerstands-Reihenschaltung zugeordnet sind (vgl. Figur 5), auf die Ansprechzeit verringert wird. Ein weiterer Vorteil ist, dass der Aufwand an Bauteilen gegenüber der in Figur 3 dargestellten Ansteuerschaltung 2" nicht erhöht ist. Ferner ist vorteilhafterweise das stabilisierte Potential an dem Zwischenanschluss bzw. dem Ausgang 200 der Widerstands-Reihenschaltung grösser als die in der Ansteuerschaltung zur Verfügung stehende Speisungs- bzw. Versorgungsspannung, insbesondere als das Steueranschluss-Signal bzw. das Potential am Steueranschluss G im eingeschalteten Zustand des Leistungshalbleiterschalters S und als das Potential Viso einer Spannungsquelle V-ON zur Speisung der Ausgangsstufe M_ON für den Einschalt- bzw. eingeschalteten Zustand des Leistungshalbleiterschalters S. Hierdurch wird die Optimierbarkeit der erfindungsgemässen Ansteuerschaltung bzw. einer Schaltungsanordnung mit einer solchen Ansteuerschaltung hinsichtlich der Konstanz der Ansprechzeit in einem weiten Bereich der Kollektor-Emitter-Spannung erheblich verbessert, sodass der unerwünschte Einfluss der der Eingangsseite der Signalverarbeitungseinheit bzw. dessen Komparator COMP zugeordneten parasitären Kapazität CAP verringert wird, ohne dass der Strom durch und damit die Verlustleistung der Widerstände RVCE1, RVCE2, RVCE3 der Widerstands-Reihenschaltung erhöht werden muss.

Es können eine oder mehrere weitere leitende Verbindungen vorgesehen sein, die jeweils einen kollektorseitigen Ausgang 301 eines der weiteren Halbleiterbauelemente DZCE2 der Halbleiterbauelement-Reihenschaltung mit einem weiteren Zwischenanschluss 201 der Widerstands-Reihenschaltung verbinden. Hierdurch kann vorteilhafterweise die Optimierbarkeit der erfindungsgemässen Ansteuerschaltung hinsichtlich thermischer Widerstände, Isolationskoordination in Bezug auf mögliche Luft- und Kriechstrecken und Variantenvielfalt (z.B. Bestückungsvarianten für verschiedene IGBT-Klassen) verbessert werden.

Mittelbar oder unmittelbar parallel zu dem kollektorfernsten Halbleiterbauelement DZCE0 der Halbleiterbauelement-Reihenschaltung ist bevorzugt ein Schalter M_DAAC angeordnet, dessen Steueranschluss CTRL_DAAC direkt oder indirekt mit einem Ausgang der Signalverarbeitungseinheit bzw. der Steuereinheit CONTROL verbunden ist. Die Ansteuerschaltung 21 ist nun derart ausgebildet, dass die Signalverarbeitungseinheit bzw. die Steuereinheit CONTROL den Schalter M_DAAC vorzugsweise im eingeschalteten Zustand des Leistungshalbleiterschalters S und vorzugsweise zu Beginn des Abschaltvorgangs des Leistungshalbleiterschalters S einschaltet. Hierdurch wird das Halbleiterbauelement DZCE0 überbrückt, und die Spannung über dem Halbleiterbauelement DZCE0 und somit die Summe der Spannungen über den Halbleiterbauelementen DZCE0, DZCE1, DZCE2, DZCE3 wird verringert, wenn die Halbleiterbauelemente DZCE0, DZCE1, DZCE2, DZCE3 während des Abschaltvorgangs des Leistungshalbleiterschalters S im Durchbruch betrieben werden. Dies führt zu einer besseren Ausnutzung der Leistungsfähigkeit des Leistungshalbleiterschalters S, ohne dass dessen sicherer Arbeitsbereich verlassen wird.

Vorteil der Stabilisierung des Potentials am Zwischenanschluss bzw. Ausgang 200 der Widerstands-Reihenschaltung ist es auch, dass ein unerwünschter Ladungstransfer während der Umschaltung des Schalters M_DAAC zur Realisierung der dynamischen Active-Clamping-Funktion zwischen den parasitären Kapazitäten CP und der Ansprechzeit-Kapazität CA verringert werden kann, was das Konstanthalten der Ansprechzeit im einem weiten Bereich der Kollektor-Emitter-Spannung noch weiter wesentlich vereinfacht.

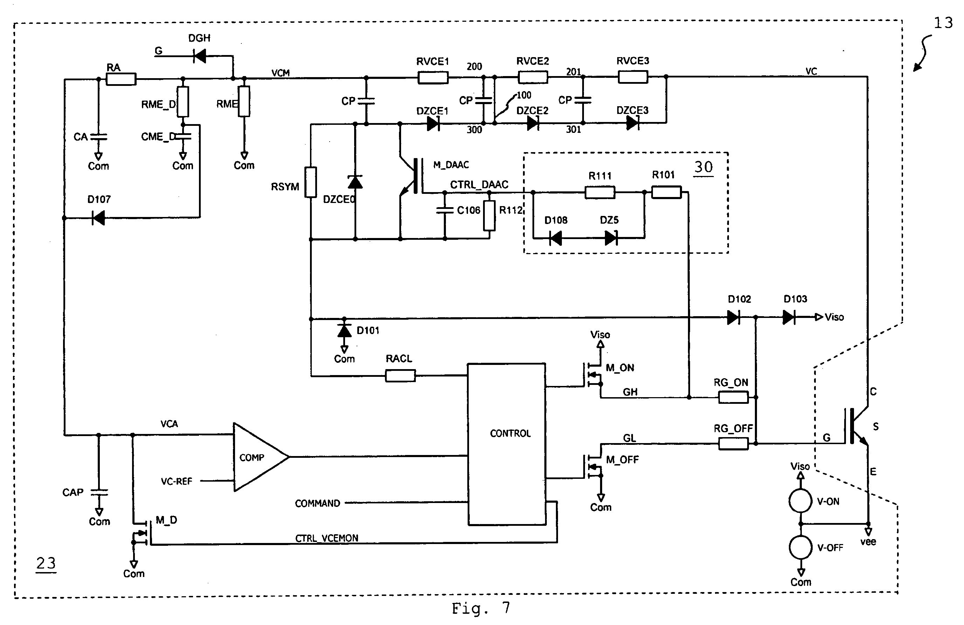

Für den Fall, dass das mit der leitfähigen Verbindung 100 verbundene Halbleiterbauelement DZCE1 aktiver Teil einer Halbleiterbauelement-Reihenschaltung zur Realisierung einer Active-Clamping-Funktion ist, wie in den Figuren 4 und 5 (und auch in Figur 7) dargestellt, erfolgt die Speisung des Halbleiterbauelements DZCE1 aus dem Kollektor C des Leistungshalbleiterschalters S über die leitfähige Verbindung 100 und die Widerstands-Reihenschaltung zur Realisierung des VCE-Monitorings, sodass vorteilhafterweise keine zusätzliche Hilfsspeisung des Halbleiterbauelements DZCE1 erforderlich ist, deren Potential die Versorgungsspannung der erfindungsgemässen Ansteuerschaltung übersteigt.

Die Spannung VCA am ersten Eingang der Signalverarbeitungseinheit bzw. des Komparators COMP und/oder die Spannung VCM am kollektorfernen Ausgang der Widerstands-Reihenschaltung sollten auf Werte begrenzt werden, die von der nachfolgenden Signalverarbeitungseinheit bzw. dem nachfolgenden Komparator COMP verarbeitet werden können. Dazu wird die Anode einer Diode DGH an den kollektorfernen Ausgang der Widerstands-Reihenschaltung (vgl. Figur 5) oder alternativ an den ersten Eingang der Signalverarbeitungseinheit bzw. des Komparators COMP angeschlossen, wobei die Kathode der Diode DGH an den Steueranschluss G des Leistungshalbleiterschalters S angeschlossen bzw. anschliessbar ist. Insbesondere im letzteren Fall kann die Diode vorteilhafterweise monolithisch, d.h. innerhalb der Signalverarbeitungseinheit bzw. des Komparators COMP, ausgeführt sein. Anstelle der Diode DGH können auch ein oder mehrere im Durchbruch betriebene Halbleiterbauelemente, beispielsweise Zener-Dioden, Avalanche-Dioden und/oder Transient-Voltage-Suppressor-Dioden, analog zu der Diode DGH an den kollektorfernen Ausgang der Widerstands-Reihenschaltung oder an den ersten Eingang der Signalverarbeitungseinheit bzw. des Komparators COMP angeschlossen werden.

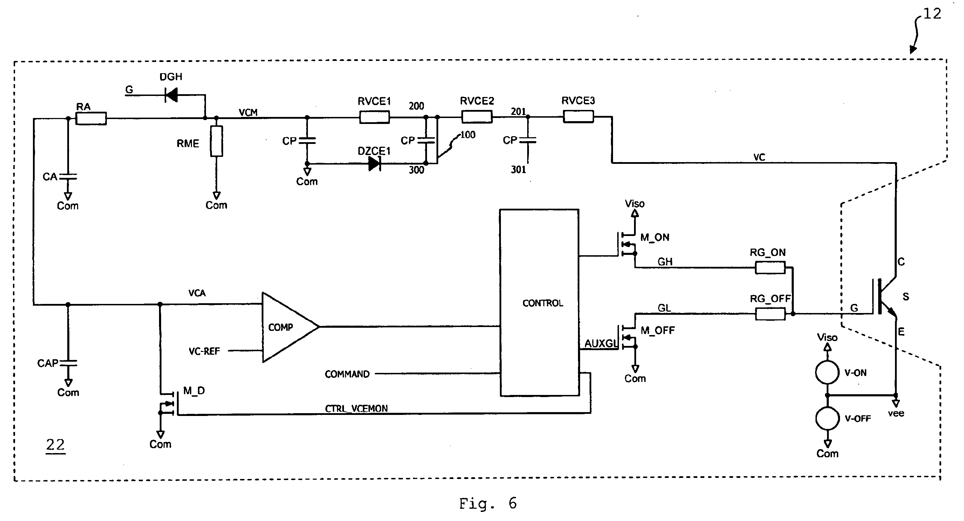

Figur 6 zeigt eine Schaltungsanordnung 12 mit einer Ansteuerschaltung 22 und einem Leistungshalbleiterschalter S. Im Unterschied zu den Figuren 4 und 5 ist nur ein Halbleiterbauelement DZCE1 vorgesehen, welches bei Überschreiten einer bestimmten, vorgegebenen Kollektor-Emitter-Spannung im Durchbruch und somit auf zumindest zeitweise konstantem Potential betrieben wird und bei dem es sich zum Beispiel um eine einzelne Zener-Diode, Avalanche-Diode oder Transient-Voltage-Suppressor-Diode handelt. Die Durchbruchspannung des Halbleiterbauelements DZCE1 ist vorzugsweise grösser als 100 V. Der kathodenseitige Ausgang 300 des Halbleiterbauelements DZCE1 ist über die leitfähige Verbindung 100 mit dem Zwischenanschluss 200 zwischen den Widerständen RVCE1 und RVCE2 der Widerstands-Reihenschaltung verbunden, sodass das Zwischenpotential am Zwischenanschluss 200 bei Überschreiten der vorgegebenen Kollektor-Emitter-Spannung durch das Potential am kathodenseitigen Ausgang 300 des Halbleiterbauelements DZCE1 stabilisiert wird. Die in Figur 5 gezeigten weiteren Halbleiterbauelemente DZCE0, DZCE2, DZCE3 und die Beschaltung mit dem über die Steuereinheit CONTROL gesteuerten Schalter M_DAAC zur Realisierung einer Active-Clamping-Funktion sind in Figur 6 entfallen,

Figur 7 zeigt eine Schaltungsanordnung 13 mit einem zweiten Ausführungsbeispiel einer erfindungsgemässen Ansteuerschaltung 23 und einem Leistungshalbleiterschalter S. Im Vergleich zu den in den Figuren 4 bis 6 dargestellten Ausführungsbeispielen ist eine der Signalverarbeitung dienende frequenz- und/oder zeitabhängige Impedanz vorgesehen, die zwischen der Widerstands-Reihenschaltung und dem Ansprechzeit-Netzwerk RA, CA und parallel zu dem Ansprechzeit-Netzwerk RA, CA angeordnet ist und dessen Eingang auf dem Potential VCM am Ausgang der Widerstands-Reihenschaltung und dessen Ausgang auf einem Bezugspotential Com oder auch vee der Ansteuerschaltung 23 liegt. Die frequenz- und/oder zeitabhängige Impedanz umfasst vorzugsweise wie in Figur 7 dargestellt eine Reihenschaltung eines Widerstandes RME_D und einer Kapazität CME_D oder eine Reihenschaltung des Widerstandes RME_D und eines von der Signalverarbeitungseinheit bzw. der Steuereinheit CONTROL gesteuerten Schalters (nicht dargestellt). Zweck der frequenz- und/oder zeitabhängigen Impedanz ist die Realisierung eines dynamischen VCE-Monitorings zusammen mit der Widerstands-Reihenschaltung. Es kann eine Diode D107 vorgesehen sein, deren Anode zwischen dem Widerstand RME_D und der Kapazität CME_D und deren Kathode an den Ausgang des Ansprechzeit-Netzwerks RA, CA bzw. an den ersten Eingang der Signalverarbeitungseinheit bzw. des Komparators COMP angeschlossen ist. Die Diode D107 dient der Beschleunigung der Entladung der Kapazität CME_D, um auch bei kurzen Ausschaltzeiten des Leistungshalbleiterschalters S eine sichere Startbedingung/einen sicheren Startzustand für die Kapazität CME_D zu gewährleisten. Das dynamische VCE-Monitoring dient der temporären Verringerung des Messwertes VCM der Kollektor-Emitter-Spannung zur vorteilhaften Kompensation des zeitlichen Verlaufs der Kollektor-Emitter-Spannung beim Einschalten des Leistungshalbleiterschalters S.

Ferner zeigt Figur 7 im Vergleich mit den Figuren 5 und 6 eine erfindungsgemässe Ansteuerschaltung 23 mit einer detaillierten Beschaltung des Schalters M_DAAC, der von der Signalverarbeitungseinheit bzw. der Steuereinheit CONTROL im eingeschalteten Zustand und zu Beginn des Abschaltzustands des Leistungshalbleiterschalters S zur Überbrückung des Halbleiterbauelements DZCE0 zur Realisierung einer dynamischen Active-Clamping-Funktion eingeschaltet wird. Während des ausgeschalteten Zustands des Leistungshalbleiters S ist der Schalter M_DAAC ausgeschaltet.

Zum Ansteuern des Schalters M_DAAC ist dessen Steueranschluss CTRL_DAAC vorzugsweise über ein Ansteuernetzwerk 30, das insbesondere aus zwei in Reihe geschalteten Widerständen R111 und R101, einer Diode D108 und einer Zener-Diode DZ5 (oder auch einer Avalanche-Diode oder einer Transient-Voltage-Suppressor-Diode) besteht, mit dem Steueranschluss G oder dem Ausgang GH (so in Figur 7 dargestellt) der für den eingeschalteten Zustand des Leistungshalbleiterschalters S zuständigen Ausgangsstufe M_ON der Signalverarbeitungseinheit bzw. Steuereinheit CONTROL verbunden. Alternativ bildet ein aus dem Verlauf des Potentials an dem Ausgang GH, des Potentials an dem Steueranschluss G oder eines Schaltbefehls COMMAND für die Signalverarbeitungseinheit bzw. der Steuereinheit CONTROL abgeleitetes bzw. ableitbares Signal das Eingangssignal für das dem Schalter M_DAAC vorgeschaltete Ansteuernetzwerk 30, d.h. das Stellsignal für den Schalter M_DAAC. Die Energie oder Steueranschluss-Ladung (Gate Charge) zum Betrieb des Schalters M_DAAC wird somit direkt aus dem regulären Steueranschluss G bzw. dem Ausgang GH der für den eingeschalteten Zustand des Leistungshalbleiterschalters S zuständigen Ausgangsstufe M_ON oder einem hieraus abgeleiteten Signal bezogen. Hierdurch kann vorteilhafterweise auf eine zusätzliche, relativ komplexe sogenannte Chargepump- oder Bootstrap-Speisung des Schalters M_DAAC verzichtet werden. Die Diode D108 und die Zener-Diode DZ5 sind anodenseitig miteinander verbunden und parallel zu dem Widerstand R111 geschaltet.

Zwischen dem Ansteuernetzwerk 30 und dem Schalter M_DAAC ist vorzugsweise eine Parallelschaltung aus einem Widerstand R112 und einer Kapazität C106 vorgesehen, die mit dem Steueranschluss des Schalters M_DAAC und mit dessen Leistungsanschluss zur Stromabführung verbunden ist. Durch den Widerstand R111 des Ansteuernetzwerks 30, die Kapazität C106 und die Eingangskapazität des Schalters M_DAAC wird der Ausschaltvorgang des Schalters M_DAAC gegenüber dem Eingangssignal des Ansteuernetzwerks 30, d.h. dem Stellsignal, das in Figur 7 beispielhaft durch das Potential am Ausgang GH der Ausgangsstufe M_ON gegeben ist, verzögert, sodass während des Ausschaltvorgangs des Leistungshalbleiterschalters S der Schalter M_DAAC eingeschaltet bleibt und erst im ausgeschalteten Zustand des Leistungshalbleiterschalters S vollständig öffnet.

Die Diode D108 dient der Beschleunigung des Einschaltvorgangs des Schalters M_DAAC, sodass auch bei kurzen Einschaltzeiten des Leistungshalbleiterschalters S sichergestellt ist, dass der Schalter M_DAAC während nachfolgender Ausschaltvorgänge des Leistungshalbleiterschalters S sicher eingeschaltet ist.

Durch den Widerstand R112 und die Zener-Diode DZ5 wird das Stellsignal für den Schalter M_DAAC dessen sicheren Arbeitsbereich entsprechend reduziert. Der Widerstand R101 dient der Reduzierung einer Spitzenstrombelastung am Steueranschluss CTRL_DAAC des Schalters M_DAAC und somit der Reduzierung einer Spitzenstrombelastung am Ausgang GH der Ausgangsstufe M_ON (welche Spitzenstrombelastung zu weniger Strom am Steueranschluss G des Leistungshalbleiterschalters S führen könnte), sodass die gesamte Stromfähigkeit der Ansteuerschaltung 23 zum Ansteuern und Betrieb des Leistungshalbleiterschalters S zur Verfügung steht.

Ferner ist dem Halbleiterbauelement DZCE0 und dem Schalter M_DAAC vorzugsweise ein Widerstand RSYM parallel geschaltet, der der Stabilisierung der Ausgangsspannung des Schalters M_DAAC dient im Falle grösserer Leckströme des Halbleiterbauelements DZCE1 bzw. im Falle von Leckströmen des Halbleiterbauelements DZCE0, die kleiner sind als Leckströme des Halbleiterbauelements DZCE1. Hierdurch kann vorteilhafterweise vermieden werden, dass es im Falle grösserer Leckströme des Halbleiterbauelements DZCE1 bzw. kleinerer Leckströme des Halbleiterbauelements DZCE0 im Vergleich zu den Leckströmen des Halbleiterbauelements DZCE1 beim Einschaltvorgang des Leistungshalbleiterschalters S zu einem Potentialsprung an dem Ausgang des Halbleiterbauelements DZCE1 der Halbleiterbauelement-Reihenschaltung kommt, an den die leitfähige Verbindung 100 angeschlossen ist. Ein solcher Potentialsprung hätte einen ungewollten Ladungstransfer von den parasitären Kapazitäten CP zu der Ansprechzeit-Kapazität CA zur Folge.

## Patentansprüche

1. Ansteuerschaltung zur Ansteuerung eines Leistungshalbleiterschalters (S) mit einer Signalverarbeitungseinheit (CONTROL) zur Erzeugung eines Steueranschluss-Signals für einen Steueranschluss (G) des Leistungshalbleiterschalters (S), wobei die Ansteuerschaltung (20; 21; 22; 23) eine Widerstands-Reihenschaltung (RCVE1, RCVE2, RCVE3) umfasst, welche an einen der Stromzuführung dienenden Leistungsanschluss (C) des Leistungshalbleiterschalters (S) angeschlossen ist und dessen Ausgang mit einem ersten Eingang der Signalverarbeitungseinheit (CONTROL) verbunden ist, und wobei die Signalverarbeitungseinheit (CONTROL) einen zweiten Eingang für eine Referenzspannung (VC-REF) für die Kollektor-Emitter-Spannung des Leistungshalbleiterschalters (S) aufweist, **dadurch gekennzeichnet, dass** wenigstens ein Halbleiterbauelement (DZCE1, DZCE2, DZCE3) vorgesehen ist, das derart ausgestaltet ist, dass es bei Überschreiten einer bestimmten Kollektor-Emitter-Spannung des Leistungshalbleiterschalters (S) im Durchbruch betrieben wird, wobei ein Ausgang (300) des wenigstens einen Halbleiterbauelements (DZCE1, DZCE2, DZCE3) über eine leitfähige Verbindung (100) mit einem Anschluss (200) zwischen den Widerständen (RCVE1, RCVE2, RCVE3) der Widerstands-Reihenschaltung oder dem Ausgang (200) der Widerstands-Reihenschaltung, der mit der Signalverarbeitungseinheit (CONTROL) verbunden ist, verbunden ist, wobei ein weiteres Halbleiterbauelement (DZCE0) vorgesehen ist, welches zu dem wenigstens einen ersten Halbleiterbauelement (DZCE1, DZCE2, DZCE3) in Reihe geschaltet ist, wobei ein Schalter (M_DAAC) parallel zu diesem weiteren Halbleiterbauelement (DZCE0) angeordnet ist, dessen Steueranschluss (CTRL_DAAC) mittelbar oder unmittelbar mit einem Ausgang der Signalverarbeitungseinheit (CONTROL) verbunden ist, an den der Steueranschluss (G) des Leistungshalbleiterschalters (S) angeschlossen ist, wobei die Ansteuerschaltung (21; 23) derart ausgebildet ist, dass die Signalverarbeitungseinheit (CONTROL) den Schalter (M_DAAC) im eingeschalteten Zustand des Leistungshalbleiterschalters (S) und/oder zu Beginn des Abschaltvorgangs des Leistungshalbleiterschalters (S) einschaltet, und wobei die Durchbruchspannung des wenigstens einen Halbleiterbauelements (DZCE1, DZCE2, DZCE3) derart gewählt ist, dass das Potential an dem Ausgang (300) des wenigstens einen Halbleiterbauelements (DZCE1, DZCE2, DZCE3) grösser als das Potential am Steueranschluss (G) des Leistungshalbleiterschalters (S) im eingeschalteten Zustand des Leistungshalbleiterschalters (S) ist.

2. Ansteuerschaltung nach Anspruch 1, **dadurch gekennzeichnet, dass** das Potential an dem Ausgang (300) des wenigstens einen Halbleiterbauelements (DZCE1, DZCE2, DZCE3), insbesondere die Durchbruchspannung des wenigstens einen Halbleiterbauelements (DZCE1, DZCE2, DZCE3), grösser als 100 V ist.

3. Ansteuerschaltung nach Anspruch 1 oder 2, **dadurch gekennzeichnet, dass** das wenigstens eine Halbleiterbauelement eine Zener-Diode, eine Avalanche-Diode und/oder Transient-Voltage-Suppressor-Diode ist.

4. Ansteuerschaltung nach einem der vorhergehenden Ansprüche, **dadurch gekennzeichnet, dass** mehrere Halbleiterbauelemente (DZCE1, DZCE2, DZCE3) vorgesehen sind, die in Reihe geschaltet sind.

5. Ansteuerschaltung nach Anspruch 4, **dadurch gekennzeichnet, dass** wenigstens eine weitere leitende Verbindung vorgesehen ist, die einen Ausgang (301) eines der weiteren Halbleiterbauelemente (DZCE2, DZCE3) mit einem weiteren Anschluss (201) zwischen den Widerständen (RCVE1, RCVE2, RCVE3) der Widerstands-Reihenschaltung verbindet.

6. Ansteuerschaltung nach einem der vorhergehenden Ansprüche, **dadurch gekennzeichnet, dass** der Ausgang der Widerstands-Reihenschaltung (RCVE1, RCVE2, RCVE3) über ein Ansprechzeit-Netzwerk (RA, CA) mit dem ersten Eingang der Signalverarbeitungseinheit (CONTROL) verbunden ist, wobei das Ansprechzeit-Netzwerk einen Ansprechzeit-Widerstand (RA) umfasst.

7. Ansteuerschaltung nach Anspruch 6, **dadurch gekennzeichnet, dass** zwischen der Widerstands-Reihenschaltung (RCVE1, RCVE2, RCVE3) und dem Ansprechzeit-Netzwerk (RA, CA) parallel zu dem Ansprechzeit-Netzwerk (RA, CA) eine frequenz- und/oder zeitabhängige Impedanz (RME_D, CME_D) vorgesehen ist, die insbesondere eine Reihenschaltung eines Widerstandes (RME_D) und einer Kapazität (CME_D) oder die Reihenschaltung eines Widerstandes und eines von der Signalverarbeitungseinheit (CONTROL) gesteuerten Schalters umfasst.

8. Verfahren zur Ansteuerung eines Leistungshalbleiterschalters (S) mit einer Ansteuerschaltung (20; 21; 22; 23) nach einem der vorhergehenden Ansprüche, wobei die Signalverarbeitungseinheit (CONTROL) aus dem an seinem ersten Eingang anliegenden Signal (VCA) und aus der Referenzspannung (VC-REF) für die Kollektor-Emitter-Spannung des Leistungshalbleiterschalters (S) ein Steueranschluss-Signal für den Steueranschluss (G) des Leistungshalbleiterschalters (S) ermittelt,
**dadurch kennzeichnet, dass** beim Überschreiten einer bestimmten Kollektor-Emitter-Spannung das wenigstens eine Halbleiterbauelement (DZCE0, DZCE1, DZCE2, DZCE3) im Durchbruch betrieben wird und das Potential an dem mit der leitfähigen Verbindung (100) verbundenen Ausgang (200) der Widerstands-Reihenschaltung (RVCE1, RVCE2, RVCE3) oder an dem mit der leitfähigen Verbindung (100) verbundenen Anschluss (200) zwischen den Widerständen (RVCE1, RVCE2, RVCE3) der Widerstands-Reihenschaltung auf einen Wert begrenzt wird, der grösser als das Potential am Steueranschluss (G) des Leistungshalbleiterschalters (S) im eingeschalteten Zustand des Leistungshalbleiterschalters (S) ist, wobei im eingeschalteten Zustand des Leistungshalbleiterschalters (S) und/oder zu Beginn des Abschaltvorgangs des Leistungshalbleiterschalters (S) die Spannung über einem weiteren Halbleiterbauelement (DZCE0), das in Reihe zu dem wenigstens einen Halbleiterbauelement (DZCE1, DZCE2, DZCE3) geschaltet ist, mittels eines parallel zu diesem weiteren Halbleiterbauelement (DZCE0) angeordneten Schalters (M_DAAC) verringert wird, wenn die Halbleiterbauelemente (DZCE1, DZCE2, DZCE3) im Durchbruch betrieben werden.

9. Verfahren nach Anspruch 8, **dadurch gekennzeichnet, dass** das Potential an dem mit der leitfähigen Verbindung (100) verbundenen Ausgang (200) der Widerstands-Reihenschaltung (RVCE1, RVCE2, RVCE3) oder an dem mit der leitfähigen Verbindung (100) verbundenen Anschluss (200) zwischen den Widerständen (RVCE1, RVCE2, RVCE3) der Widerstands-Reihenschaltung auf einen Wert begrenzt wird, der grösser als 100 V ist.

10. Verfahren nach Anspruch 8 oder 9, **dadurch gekennzeichnet, dass** bei Überschreiten der Durchbruchspannung des wenigstens einen Halbleiterbauelements (DZCE0, DZCE1, DZCE2, DZCE3) die Signalverarbeitungseinheit (CONTROL) den Wert des Steueranschluss-Signals für den Steueranschluss (G) des Leistungshalbleiterschalters (S) erhöht.

11. Verfahren nach Anspruch 8, **dadurch gekennzeichnet, dass** das Stellsignal für den parallel zu dem weiteren Halbleiterbauelement (DZCE0) angeordneten Schalter (M_DAAC) durch das Steueranschluss-Signal für den Steueranschluss (G) des Leistungshalbleiterschalters (S) gebildet oder aus diesem abgeleitet oder aus einem Schaltbefehl (COMMAND) für die Signalverarbeitungseinheit (CONTROL) abgeleitet wird.

## Claims

1. A driving circuit for driving a power semiconductor switch (S), comprising a signal-processing unit (CONTROL) for generating a gate signal for a gate (G) of the power semiconductor switch (S), the driving circuit (20; 21; 22; 23) comprising a resistor series circuit (RCVE1, RCVE2, RCVE3) which is connected to a power terminal (C) used for the current supply of the power semiconductor switch (S), and whose output is connected to a first input of the signal-processing unit (CONTROL), and the signal-processing unit (CONTROL) having a second input for a reference voltage (VC-REF) for the collector-emitter voltage of the power semiconductor switch (S), **characterized in that** at least one semiconductor device (DZCE1, DZCE2, DZCE3) is provided which is implemented in such a way that it is operated in breakdown in response to the exceedance of a specific collector-emitter voltage of the power semiconductor switch (S), an output (300) of the at least one semiconductor device (DZCE1, DZCE2, DZCE3) being connected via a conductive interconnect (100) to a terminal (200) between the resistors (RCVE1, RCVE2, RCVE3) of the resistor series circuit or to the resistor-series-circuit output (200) which is connected to the signal-processing unit (CONTROL), a further semiconductor device (DZCE0) being provided which is connected in series to the at least one first semiconductor device (DZCE1, DZCE2, DZCE3), a switch (M_DAAC) being positioned parallel to this further semiconductor device (DZCE0) and its gate (CTRL_DAAC) being connected indirectly or directly to an output of the signal-processing unit (CONTROL), to which output the gate (G) of the power semiconductor switch (S) is connected, the driving circuit (21; 23) being implemented in such a way that the signal-processing unit (CONTROL) closes the switch (M_DAAC) in the ON state of the power semiconductor switch (S) and/or at the beginning of the circuit-breaking operation of the power semiconductor switch (S), and the breakdown voltage of the at least one semiconductor device (DZCE1, DZCE2, DZCE3) being selected in such a way that the potential at the output (300) of the at least one semiconductor device (DZCE1, DZCE2, DZCE3) is greater than the potential at the gate (G) of the power semi-conductor switch (S) in the ON state of the power semiconductor switch (S).

2. The driving circuit according to claim 1, wherein the potential at the output (300) of the at least one semiconductor device (DZCE1, DZCE2, DZCE3), particularly the breakdown voltage of the at least one semiconductor device (DZCE1, DZCE2, DZCE3), is greater than 100 V.

3. The driving circuit according to claim 1 or 2, wherein the at least one semiconductor device is a Zener diode, an avalanche diode and/or transient-voltage suppressor diode.

4. The driving circuit according to one of the preceding claims, wherein a plurality of semiconductor devices (DZCE1, DZCE2, DZCE3) are provided, which are connected in series.

5. The driving circuit according to claim 4, wherein at least one further conductive interconnect is provided which connects an output (301) of one of the further semiconductor devices (DZCE2, DZCE3) to a further terminal (201) between the resistors (RCVE1, RCVE2, RCVE3) of the resistor series circuit.

6. The driving circuit according to one of the preceding claims, wherein the output of the resistor series circuit (RCVE1, RCVE2, RCVE3) is connected via a response-time network (RA, CA) to the first input of the signal-processing unit (CONTROL), the response-time network comprising a response-time resistor (RA).

7. The driving circuit according to claim 6, wherein between the resistor series circuit (RCVE1, RCVE2, RCVE3) and the response-time network (RA, CA) and parallel to the response-time network (RA, CA) a frequency-dependent and/or time-dependent impedance (RME_D, CME_D) is provided which, in particular, comprises a series connection of a resistor (RME_D) and a capacitor (CME_D), or the series connection of a resistor and a switch controlled by the signal-processing unit (CONTROL).

8. A method for driving a power semiconductor switch (S) having a driving circuit (20; 21; 22; 23) according to one of the preceding claims, the signal-processing unit (CONTROL) determining from the signal (VCA) applied to its first input and from the reference voltage (VC-REF) for the collector-emitter voltage of the power semiconductor switch (S), a gate signal for the gate (G) of the power semiconductor switch (S), **characterized in that** in response to the exceedance of a specific collector-emitter voltage the at least one semiconductor device (DZCE1, DZCE2, DZCE3) is operated in breakdown and the potential at that output (200) of the resistor series circuit (RVCE1, RVCE2, RVCE3) which is connected with the conductive interconnect (100) or at the terminal (200) which is between the resistors (RVCE1, RVCE2, RVCE3) of the resistor series circuit and is connected with the conductive interconnect (100) is limited to a value which is greater than the potential at gate (G) of the power semiconductor switch (S) in the ON state of the power semiconductor switch (S), wherein in at least one of the ON state of the power semiconductor switch (S) and the beginning of the circuit-breaking operation of the power semiconductor switch (S) the voltage across a further semiconductor device (DZCE0), which is connected in series to the at least one semiconductor device (DZCE1, DZCE2, DZCE3), is reduced by means of a switch (M_DAAC) positioned parallel to this further semiconductor device (DZCE0), when the semiconductor devices (DZCE1, DZCE2, DZCE3) are operated in breakdown mode.

9. The method according to claim 8, wherein the potential at that output (200) of the resistor series circuit (RVCE1, RVCE2, RVCE3) which is connected with the conductive interconnect (100) or at the terminal (200) which is between the resistors (RVCE1, RVCE2, RVCE3) of the resistor series circuit and is connected with the conductive interconnect (100), is limited to a value which is greater than 100 V.

10. The method according to claim 8 or 9, wherein in response to the exceedance of the breakdown voltage of the at least one semiconductor device (DZCE0, DZCE1, DZCE2, DZCE3) the signal-processing unit (CONTROL) increases the value of the gate signal for the gate (G) of the power semiconductor switch (S).

11. The method according to claim 8, wherein the actuating signal for the switch (M_DAAC) positioned parallel to the further semiconductor device (DZCE0) is formed by the gate signal for the gate (G) of the power semiconductor switch (S) or is derived from it or from a switching command (COMMAND) for the signal-processing unit (CONTROL).

## Revendications

1. Circuit de commande destiné à commander un commutateur de puissance à semi-conducteur (S) comportant une unité de traitement du signal (CONTROL) destinée à générer un signal de connexion de commande pour une connexion de commande (G) du commutateur de puissance à semi-conducteur (S), dans lequel le circuit de commande (20 ; 21 ; 22 ; 23) comprend un circuit série de résistances (RCVE1, RCVE2, RCVE3) qui est connecté à une borne de puissance (C) servant à l'alimentation en courant du commutateur de puissance à semi-conducteur (S) et dont la sortie est reliée à une première entrée de l'unité de traitement du signal (CONTROL), et dans lequel l'unité de traitement du signal (CONTROL) présente une seconde entrée destinée à une tension de référence (VC-REF) pour la tension collecteur-émetteur du commutateur de puissance à semi-conducteur (S), **caractérisé en ce qu'**il est prévu au moins un composant à semi-conducteur (DZCE1, DZCE2, DZCE3) qui est conçu de manière à être attaqué en mode claquage lors du dépassement d'une tension collecteur-émetteur spécifique du commutateur de puissance à semi-conducteur (S), dans lequel une sortie (300) de l'au moins un composant à semi-conducteur (DZCE1, DZCE2, DZCE3) est reliée par l'intermédiaire d'une liaison conductrice (100) à une borne (200) située entre les résistances (RCVE1, RCVE2, RCVE3) du circuit série de résistances ou à la sortie (200) du circuit série de résistances qui est relié à l'unité de traitement du signal (CONTROL), dans lequel il est prévu un autre composant à semi-conducteur (DZCE0) qui est connecté à l'au moins un premier composant à semi-conducteur (DZCE1, DZCE2, DZCE3), dans lequel un commutateur (M_DAAC) est disposé en parallèle à cet autre composant à semi-conducteur (DZCE0) dont la borne de commande (CTRL_DAAC) est directement ou indirectement reliée à une sortie de l'unité de traitement du signal (CONTROL), à laquelle est reliée la borne de commande (G) du commutateur de puissance à semi-conducteur (S), dans lequel le circuit de commande (21 ; 23) est conçu de telle manière que l'unité de traitement du signal (CONTROL) rende passant le commutateur (M_DAAC) à l'état passant du commutateur de puissance à semi-conducteur (S) et/ou au début du processus de passage à l'état passant du commutateur de puissance à semi-conducteur (S), et dans lequel la tension de claquage de l'au moins un composant à semi-conducteur (DZCE1, DZCE2, DZCE3) est sélectionnée de manière à ce que le potentiel à la sortie (300) de l'au moins un composant à semi-conducteur (DZCE1, DZCE2, DZCE3) soit supérieur au potentiel sur la borne de commande (G) du commutateur de puissance à semi-conducteur (S) à l'état passant du commutateur de puissance à semi-conducteur (S).

2. Circuit de commande selon la revendication 1, **caractérisé en ce que** le potentiel sur la sortie (300) de l'au moins un composant à semi-conducteur (DZCE1, DZCE2, DZCE3), notamment la tension de claquage de l'au moins un composant à semi-conducteur (DZCE1, DZCE2, DZCE3), est supérieur à 100 V.

3. Circuit de commande selon la revendication 1 ou 2, **caractérisé en ce que** l'au moins un composant à semi-conducteur est une diode Zener, une diode à avalanche et/ou une diode de suppression de tension transitoire.

4. Circuit de commande selon l'une quelconque des revendications précédentes, **caractérisé en ce qu'**il est prévu une pluralité de composants à semi-conducteur (DZCE1, DZCE2, DZCE3) qui sont connectés en série.

5. Circuit de commande selon la revendication 4, **caractérisé en ce qu'**il est prévu au moins une autre liaison conductrice qui relie une sortie (301) de l'un des autres composants à semi-conducteur (DZCE2, DZCE3) à une autre borne (201) située entre les résistances (RCVE1, RCVE2, RCVE3) du circuit série de résistances.

6. Circuit de commande selon l'une quelconque des revendications précédentes, **caractérisé en ce que** la sortie du circuit série de résistances (RCVE1, RCVE2, RCVE3) est reliée par l'intermédiaire d'un réseau de temps de réponse (RA, CA) à la première entrée de l'unité de traitement du signal (CONTROL), le réseau de temps de réponse comprenant une résistance de temps de réponse (RA).

7. Circuit de commande selon la revendication 6, **caractérisé en ce que**, entre le circuit série de résistances (RCVE1, RCVE2, RCVE3) et le réseau de temps de réponse (RA, CA), il est prévu en parallèle au réseau de temps de réponse (RA, CA), une impédance dépendant de la fréquence et/ou du temps (RME_D, CME_D), qui comprend notamment un circuit série d'une résistance (RME_D) et d'une capacité (CME_D) ou le circuit série d'une résistance et d'un commutateur commandé par l'unité de traitement du signal (CONTROL).

8. Procédé de commande d'un commutateur de puissance à semi-conducteur (S) comportant un circuit de commande (20 ; 21 ; 22 ; 23) selon l'une quelconque des revendications précédentes, dans lequel l'unité de traitement du signal (CONTROL) détermine à partir du signal (VCA) présent sur sa première entrée, et de la tension de référence (VC-REF) destinée à la tension collecteur-émetteur du commutateur de puissance à semi-conducteur (S), un signal de connexion de commande destiné à la connexion de commande (G) du commutateur de puissance à semi-conducteur (S), **caractérisé en ce que**, lors du dépassement d'une tension collecteur-émetteur déterminée, l'au moins un composant à semi-conducteur (DZCE0, DZCE1, DZCE2, DZCE3) est attaqué en mode claquage et **en ce que** le potentiel sur la sortie (200) reliée par la liaison conductrice (100) du circuit série de résistances (RVCE1, RVCE2, RVCE3) ou sur la borne (200) reliée par la liaison conductrice (100) située entre les résistances (RVCE1, RVCE2, RVCE3) du circuit série de résistances, est limité à une valeur qui est supérieure au potentiel sur la borne de commande (G) du commutateur de puissance à semi-conducteur (S) à l'état passant du commutateur de puissance à semi-conducteur (S), dans lequel, à l'état passant du commutateur de puissance à semi-conducteur (S) et/ou au début du processus de passage à l'état non passant du commutateur de puissance à semi-conducteur (S), la tension aux bornes d'un autre composant à semi-conducteur (DZCE0) qui est connecté en série à l'au moins un composant à semi-conducteur (DZCE1, DZCE2, DZCE3), est réduite au moyen d'un commutateur (M_DAAC) disposé en parallèle à cet autre composant à semi-conducteur (DZCE0) lorsque les composants à semi-conducteur (DZCE1, DZCE2, DZCE3) sont attaqués en mode claquage.

9. Procédé selon la revendication 8, **caractérisé en ce que** le potentiel sur la sortie (200) reliée par la liaison conductrice (100) du circuit série de résistances (RVCE1, RVCE2, RVCE3) ou à la borne (200) reliée par la liaison conductrice (100) située entre les résistances (RVCE1, RVCE2, RVCE3) du circuit série de résistances est limité à une valeur supérieure à 100 V.

10. Procédé selon la revendication 8 ou 9, **caractérisé en ce que**, lors du dépassement de la tension de claquage de l'au moins un composant à semi-conducteur (DZCE0, DZCE1, DZCE2, DZCE3), l'unité de traitement du signal (CONTROL) augmente la valeur du signal de connexion de commande destiné à la connexion de commande (G) du commutateur de puissance à semi-conducteur (S).

11. Procédé selon la revendication 8, **caractérisé en ce que** le signal de réglage destiné au commutateur (M_DAAC) disposé en parallèle à l'autre composant à semi-conducteur (DZCE0) est formé par le signal de connexion de commande destiné à la connexion de commande (G) du commutateur de puissance à semi-conducteur (S) ou est dérivé de celui-ci ou est dérivé d'un ordre de commutation (COMMAND) destiné à l'unité de traitement du signal (CONTROL).
